# EUROPEAN PATENT APPLICATION

(11) **EP 4 848 912 A1**
(43) Date of publication of application: **02.12.2026**
(21) Application number: 25179219.8
(22) Date of filing: 27.05.2025
(51) Int. Cl.: H05K 3/34, H01L 23/14, H01L 23/538, H05K 1/18

(54) **POWER IN PACKAGE (PIP) FOR SYSTEM IN PACKAGE (SIP)**

(71) Applicant: Harman Becker Automotive Systems, Inc., Novi, MI 48377 (US)
(72) Inventor: BICKEL, Roman, 75203 Koenigsbach (DE)
(74) Representative: Maucher Jenkins Patent- und Rechtsanwälte Partnerschaft mbB

(57) **Abstract**

A system in package (SIP), a printed circuit board (PCB) and a system including the SIP and the PCB. The SIP including a substrate, the substrate including a first surface on a top side of the substrate and a second surface on a bottom side of the substrate, wherein the top side is opposite to the bottom side. The SIP including an integrated circuit disposed on the first surface of the substrate and memory disposed on the first surface of the substrate, the memory coupled to the integrated circuit. The SIP including one or more pads on the second surface of the substrate, each of the one or more pads electrically coupled to the integrated circuit, wherein the one or more pads are each electrically coupled to a through-silicon via (TSV) of a mainboard, the one or more TSVs coupled to a power circuit of a second substrate, wherein the mainboard is a printed circuit board (PCB). The PCB including a substrate, the substrate comprising a first surface on a top side of the substrate and a second surface on a bottom side of the substrate, wherein the top side is opposite to the bottom side. The PCB including a power circuit disposed on the second surface of the substrate and one or more pads on the first surface of the substrate, each of the one or more pads electrically coupled to the power circuit, wherein the one or more pads are each electrically coupled to a through-silicon via (TSV) of a mainboard, the one or more TSVs coupled to an integrated circuit of a first substrate, wherein the mainboard is a printed circuit board (PCB).

## Description

The present invention relates to a system in package (SIP), a power in package (PIP) on a printed circuit board, and a system comprising a SIP and a PIP. In particular, the invention relates to a separate power in package (PIP) arrangement for one or more systems on a chip (SOC) or systems in package (SIP).

### BACKGROUND OF THE INVENTION

Systems on a chip (SOC) are known as integrated circuits (ICs) that combine all necessary components of a computer or other electronic system onto a single microchip. Systems in package (SIP) is a known packaging technology that combines multiple integrated circuits (ICs) and other components onto a single package to achieve a system-level function. Unlike a system on a chip (SOC) which integrates all components on a single die, SIP uses multiple dies, often with varying functionality, and connects them within a package. Typical SIP will include one more SOC, memory circuits (for example, one or more memory boards) and one or more power circuits (for example, power supplies) on the same printed circuit board (PCB).

With the increased demand on integrated circuits, SOCs and memory take up more space and require more current and electricity to be powered sufficiently. Accordingly, the packaging of current and future SIPs have grown to large and complex packages. However, current demands in electronic devices are to reduce the physical size of electronic devices. Accordingly, there is a need in the industry for better packaged SIPS.

### SUMMARY

To achieve the above objectives, the invention sets out a System In Package (SIP), a Printed Circuit Board (PCB), and a system including the SIP and the PIP as in the claims below.

In a preferred embodiment, a system in package (SIP) is provided. The SIP includes a substrate, the substrate including a first surface on a top side of the substrate and a second surface on a bottom side of the substrate, wherein the top side is opposite to the bottom side. The SIP includes an integrated circuit disposed on the first surface of the substrate and memory disposed on the first surface of the substrate, the memory coupled to the integrated circuit. The SIP includes one or more pads on the second surface of the substrate, each of the one or more pads electrically coupled to the integrated circuit, wherein the one or more pads are each electrically coupled to a through-silicon via (TSV) of a mainboard, the one or more TSVs coupled to a power circuit of a second substrate, and wherein the mainboard is a printed circuit board (PCB).

Advantageously, an integrated circuit package is provided without a dedicated power chip, power circuit or power supply. Accordingly, the integrated circuit package (the SIP) can be designed to be a much smaller package due to the placement of a separate power circuit (or power supply) that is not part of the SIP. The provided SIP has all of the advantages of a legacy SIP with the added advantage of a reduced footprint, providing more space for system on a chip (SoC) and memory components. Moreover, in legacy arrangements, power is typically provided by a mainboard to the power circuit (power supply) of the SIP. Accordingly, legacy arrangements require a mainboard that has dedicated power layers (often 6 to 8 additional layers) which can lead to a thicker mainboard. By providing a SIP that is powered by a separate power circuit, the thickness (and thus the footprint) of the mainboard is also reduced, thus providing improved packaging in computing systems. Further still, complexity of the SIP is reduced by reducing the types of components within the SIP. This leads to reduced development efforts and engineering costs. This can help SOC suppliers bring their costs down and to bring SOC into the market more quickly.

In an embodiment, the SIP further includes a plurality of power rails, each of the plurality of power rails coupled to a pad and coupled to the integrated circuit. Advantageously, the SIP is directly powered by the power circuit and does not have to be powered by the mainboard. Therefore, the mainboard does not require any dedicated layers to provide power to the SIP. Accordingly, the thickness (and thus the footprint) of the mainboard is reduced, thus providing improved packaging in computing systems.

In a preferred embodiment, a printed circuit board (PCB) is provided. The PCB includes a substrate, the substrate including a first surface on a top side of the substrate and a second surface on a bottom side of the substrate, wherein the top side is opposite to the bottom side. The PCB includes a power circuit disposed on the second surface of the substrate. The PCB includes one or more pads on the first surface of the substrate, each of the one or more pads electrically coupled to the power circuit, wherein the one or more pads are each electrically coupled to a through-silicon via (TSV) of a mainboard, the one or more TSVs coupled to an integrated circuit of a first substrate, wherein the mainboard is a printed circuit board (PCB).

Advantageously, a dedicated and separate power supply (power in package, PIP) is provided for a SIP. SIPs with a dedicated and separate power supply can be designed to be a much smaller package due to the placement of a separate power circuit (or power supply) that is not part of the SIP. Such a SIP has all of the advantages of a legacy SIP with the added advantage of a reduced footprint, providing more space for system on a chip (SoC) and memory components. Moreover, in legacy arrangements, power is typically provided by a mainboard to the power circuit (power supply) of the SIP. Accordingly, legacy arrangements require a mainboard that has dedicated power layers (often 6 to 8 additional layers) which can lead to a thicker mainboard. By providing a SIP that is powered by a separate power circuit, the thickness (and thus the footprint) of the mainboard is also reduced, thus providing improved packaging in computing systems. Further still, complexity of the SIP is reduced by reducing the types of components within the SIP. This leads to reduced development efforts and engineering costs. Further still, the PIP may be a predeveloped module, further reducing complexity and improving quality. Further, by providing a dedicated power supply in package (PIP), system costs of mainboards and the SIP are reduced in that the PIP is only provided when it is needed, compared to legacy arrangements where the typical mainboard would always include power rails, even if they are not required.

In an embodiment, the PCB further includes a plurality of power rails, each of the plurality of power rails coupled to a pad and coupled to the power circuit. Advantageously, the PIP directly powers the SIP and the SIP does not have to be powered by the mainboard. Therefore, the mainboard does not require any dedicated layers to provide power to the SIP. Accordingly, the thickness (and thus the footprint) of the mainboard is reduced, thus providing improved packaging in computing systems.

In a preferred embodiment a system is provided. The system includes a mainboard, wherein the mainboard is a printed circuit board (PCB), the mainboard including a first surface on a top side of the mainboard and a second surface on a bottom side of the mainboard, wherein the top side is opposite to the bottom side. The system includes a first substrate disposed on the first surface of the mainboard, the first substrate including a first surface on a top side of the first substrate and a second surface on a bottom side of the first substrate, wherein the top side is opposite to the bottom side. The system includes a second substrate disposed on the second surface of the mainboard, the second substrate including a first surface on a top side of the second substrate and a second surface on a bottom side of the second substrate, wherein the top side is opposite to the bottom side, wherein the mainboard includes one or more through-silicon vias (TSVs) between the first surface of the mainboard and the second surface of the mainboard, the one or more TSV electrically coupling the first substrate to the second substrate.

Advantageously, a system with one or more SIPs is provided with improved packaging. By separating the power circuit to a separate power in package (PIP) on a PCB, both the upper and the lower sides of the mainboard can be used for packaging purposes. Valuable real estate on the (relative) upper side of the mainboard was previously reserved for the entire legacy SIP which included power circuits and power supplies in the SIP. With the present arrangement, the SIP takes up less space on the (relative) upper side of the mainboard which provides more space for more SIPs and/or more powerful SIPs (i.e. SIPs with increased memory and/or more complex SOC). Therefore, more complex and/or more powerful systems can be provided in a similar sized or indeed smaller package than in legacy systems.

In an embodiment, the first substrate is a system in package (SIP). The SIP includes an integrated circuit disposed on the first surface of the first substrate and memory disposed on the first surface of the first substrate, the memory coupled to the integrated circuit. The SIP includes one or more pads on the second surface of the first substrate, each of the one or more pads electrically coupled to the integrated circuit, wherein the one or more pads are each electrically coupled to the through-silicon via (TSV) of the mainboard, the one or more TSVs coupled to a power circuit of the second substrate.

In an embodiment, the first substrate may be one or more of a field-programmable gate array (FPGA), a compute process unit (CPU), a graphics process unit (GPU), or one or more ethernet switches. Advantageously, direct power can be provided to a plurality of different types of chips, arrays, and devices coupled to or disposed on a mainboard without the mainboard requiring power routing layers. Thus, the overall package size can be reduced.

In an embodiment, the second substrate is a printed circuit board (PCB). The PCB includes a power circuit disposed on the second surface of the second substrate. The PCB includes one or more pads on the first surface of the substrate, each of the one or more pads electrically coupled to the power circuit, wherein the one or more pads are each electrically coupled to the through-silicon via (TSV) of the mainboard, the one or more TSVs coupled to an integrated circuit of the first substrate.

In an embodiment, each of the pads of the first substrate are positioned directly above each of the pads of the second substrate. Advantageously, each SIP is provided with a dedicated PIP with the shortest distance possible between the SIP and the dedicated PIP. Thus, direct power can be provided easily with the least amount of loss due to distance travelled by current.

In an embodiment, the first substrate does not include a power circuit.

In an embodiment, the power circuit of the second substrate provides power only to the first substrate. Advantageously, a dedicated and separate power supply (power in package, PIP) is provided for a SIP. SIPs with a dedicated and separate power supply can be designed to be a much smaller package due to the placement of a separate power circuit (or power supply) that is not part of the SIP. Such a SIP has all of the advantages of a legacy SIP with the added advantage of a reduced footprint, providing more space for system on a chip (SoC) and memory components. Further, by providing a dedicated power supply in package (PIP), system costs of mainboards and the SIP are reduced in that the PIP is only provided when it is needed, compared to legacy arrangements where the typical mainboard would always include power rails, even if they are not required.

In an embodiment, the mainboard includes a plurality of signal routing layers.

In an embodiment, the mainboard does not include a power routing layer. Advantageously, the thickness (and thus the footprint) of the mainboard is reduced, thus providing improved packaging in computing systems.

In an embodiment, an electronic device is provided, the electronic device including the system as described above.

In an embodiment, the electronic device is at least one of an automotive computer unit, an advanced driver-assistance system (ADAS) unit, a network ethernet router, a server, a user equipment device, or a personal computer.

### BRIEF DESCRIPTION OF THE DRAWINGS

The features, objects, and advantages of the present disclosure will become more apparent from the detailed description set forth below when taken in conjunction with the drawings in which like reference numerals refer to similar elements.
Figure 1 illustrates a top-down view of a current, prior art System In Package (SIP);
Figure 2a illustrates a top-down view of a SIP, according to the invention;
Figure 2b illustrates a top-down view of a Power In Package (PIP), according to the invention;
Figure 3 illustrates a side view of a system, the system including a SIP and a PIP each coupled to a mainboard, the PIP providing power to the SIP, according to the invention;
Figure 4 illustrates a top-down view of the system depicted in Figure 3;
Figure 5a illustrates a top-down view of the system depicted in Figure 3 with multiple SIPs; and
Figure 5b illustrates a bottom-up view of the system depicted in Figures 3 and 5a with multiple PIPs.

### DETAILED DESCRIPTION

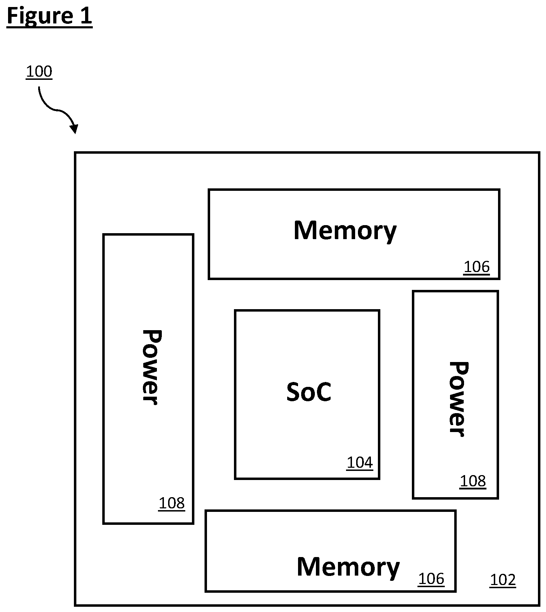

Figure 1 illustrates a top-down view of a legacy System In Package (SIP) system 100. The legacy SIP system 100 includes a mainboard 102, a System on a Chip (SOC) 104, one or more memory chips 106, and one or more power chips 108. Although one SOC 104, two memory chips 106, and two power chips 108 are shown in figure 1, legacy SIP systems 100 may include any number of SOC 104, memory chips 106, and power circuits 108. In the legacy SIP system 100 shown in figure 1, all of the chips are mounted or disposed on one surface (a top surface) of the mainboard 102. In other words, none of the main components (including the SOC 104, the memory 106 and the power circuits 108) are mounted or disposed on the surface opposite to the top surface of the mainboard 102. The terms disposed and/or mounted herein refer to any suitable manner of attaching a chip to a PCB. For example, this may include being soldered on to the PCB, etched and printed on to the PCB, coupled to the PCB, or any other suitable manner.

The mainboard 102 may be a printed circuit board (PCB) comprising a plurality of signal routing layers and a plurality of power routing layers. Typical legacy mainboards comprise 6 to 8 signal routing layers and 4 to 6 power routing layers, but other numbers of signal routing and power routing layers are known.

The SOC 104 may be any type of SOC (or integrated circuit (IC)) that combines all necessary components of a computer or other electronic system onto a single microchip.

The memory 106 may be any type of memory chip suitable for storing code for the SOC 104. The power circuits 108 may include one or more components operable to receive a current from the mainboard 102, operable to alter the current for each of the components of the SIP system 100 (such as the SOC 104 and/or the memory 106), and operable to provide the altered current to each of the components of the SIP system 100.

With the increased demand on integrated circuits, SOCs and memory take up more space and require more current and electricity to be powered sufficiently. Accordingly, the packaging of current and future SIPs have grown to large and complex packages. However, current demands in electronic devices are to reduce the physical size of electronic devices. Accordingly, there is a need in the industry for better packaged SIPS.

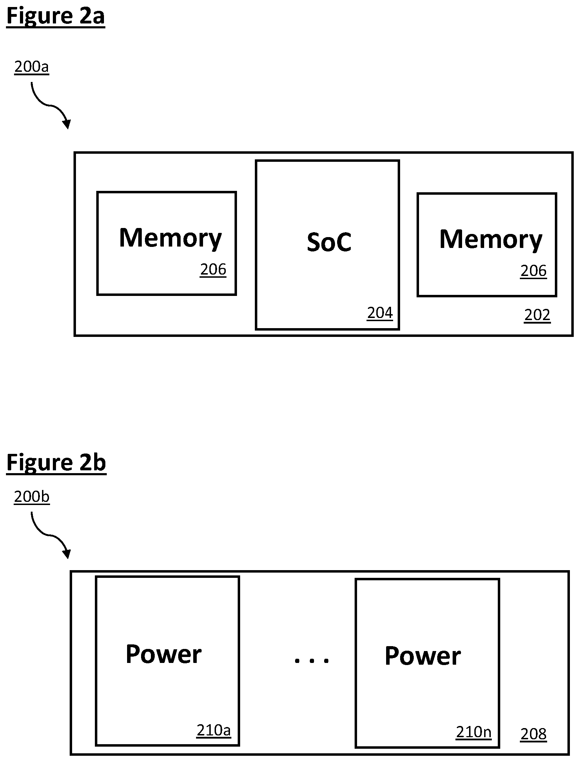

Figure 2a illustrates a top-down view of a System in Package (SIP) 200a, according to the invention. The SIP includes a substrate 202 that may be any suitable substrate (such as a printed circuit board (PCB)). The substrate includes a first surface on a top side of the substrate 202 and a second surface on a bottom side of the substrate 202, wherein the top side is opposite to the bottom side. The SIP 200a includes an integrated circuit 204 (such as a System on a Chip (SOC)) disposed on the first surface of the substrate 202. The SIP 200a includes at least one memory 206 (for example, a memory circuit, a memory chip, or similar) disposed on the first surface of the substrate 202. Figure 2a shows two memory 206 however, the invention is not limited to two memory circuits or memory chips and may include one or any other number of memory circuits or memory chips. The memory 206 is coupled (to send and receive current and signals) to the integrated circuit 204. The memory 206 may be coupled to the integrated circuit 204 via one or more electrical connections between the integrated circuit 204 and the memory 206. These one or more electrical connections may be disposed on the first surface of the substrate 202, within the substrate 202, or a combination thereof.

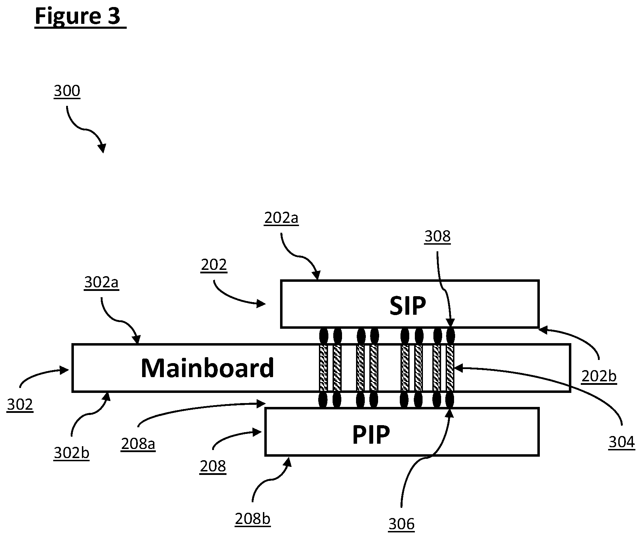

The SIP 200a includes one or more pads (not shown) on the second surface of the substrate. Each of the one or more pads are electrically coupled to the integrated circuit 204. In an embodiment, one or more of the plurality of pads may be electrically coupled to one or more memory 206. The SIP 200a may be mounted on to a mainboard (for example, a PCB) as described in figures 3 to 5 below. Each of the one or more pads are electrically coupled to a through-silicon via (TSV) of the mainboard. Each of the one or more TSVs are coupled to a power circuit, the power circuit disposed on a second substrate (for example, a Power in Package (PIP) as described in figure 2b) that is separate from the SIP 200a and that is coupled to the mainboard.

Advantageously, an integrated circuit package is provided without a dedicated power chip, power circuit or power supply. Accordingly, the integrated circuit package (the SIP) can be designed to be a much smaller package due to the placement of a separate power circuit (or power supply) that is not part of the SIP. The provided SIP has all of the advantages of a legacy SIP with the added advantage of a reduced footprint, providing more space for system on a chip (SoC) and memory components. Moreover, in legacy arrangements, power is typically provided by a mainboard to the power circuit (power supply) of the SIP. Accordingly, legacy arrangements require a mainboard that has dedicated power layers (often 6 to 8 additional layers) which can lead to a thicker mainboard. By providing a SIP that is powered by a separate power circuit, the thickness (and thus the footprint) of the mainboard is also reduced, thus providing improved packaging in computing systems. Further still, complexity of the SIP is reduced by reducing the types of components within the SIP. This leads to reduced development efforts and engineering costs. This can help SOC suppliers bring their costs down and to bring SOC into the market more quickly.

The SIP 200a may further include a plurality of power rails, each of the plurality of power rails coupled to a pad and coupled to the integrated circuit. In an embodiment, the SIP 200a may include anywhere between (and including) ten power rails and a 5000 power rails. In a preferred embodiment, the SIP 200a may include more than 30 power rails. In a further preferred embodiment, the SIP 200a may include 300 power rails. Advantageously, the SIP is directly powered by the power circuit and does not have to be powered by the mainboard. Therefore, the mainboard does not require any dedicated layers to provide power to the SIP. Accordingly, the thickness (and thus the footprint) of the mainboard is reduced, thus providing improved packaging in computing systems.

Figure 2b illustrates a top-down view of a Power In Package (PIP) 200b, according to the invention. The PIP 200b is a PCB including a substrate 208, the substrate including a first surface on a top side of the substrate 208 and a second surface on a bottom side of the substrate 208, wherein the top side is opposite to the bottom side. The PCB or PIP 200b includes one or more power circuits 210 (a, n) disposed on the second surface of the substrate 208. Figure 2b shows two power circuits 210a and 210n however, the invention is not limited to two power circuits and may include one or any other number of power circuits. The PCB or PIP 200b includes one or more pads on the first surface of the substrate, each of the one or more pads electrically coupled to one or more of the power circuits 210a. The one or more pads are each electrically coupled to a through-silicon via (TSV) of a mainboard (for example, the mainboard (the PCB) as described above in figure 2a and also in figures 3 to 5). The one or more TSVs are coupled to an integrated circuit (for example the integrated circuit or SOC 204 as described above), the integrated circuit disposed on a first substrate (for example substrate 202 as described above) corresponding to the SIP 200a as described above.

Advantageously, a dedicated and separate power supply (power in package, PIP) is provided for a SIP. SIPs with a dedicated and separate power supply can be designed to be a much smaller package due to the placement of a separate power circuit (or power supply) that is not part of the SIP. Such a SIP has all of the advantages of a legacy SIP with the added advantage of a reduced footprint, providing more space for system on a chip (SoC) and memory components. Moreover, in legacy arrangements, power is typically provided by a mainboard to the power circuit (power supply) of the SIP. Accordingly, legacy arrangements require a mainboard that has dedicated power layers (often 6 to 8 additional layers) which can lead to a thicker mainboard. By providing a SIP that is powered by a separate power circuit, the thickness (and thus the footprint) of the mainboard is also reduced, thus providing improved packaging in computing systems. Further still, complexity of the SIP is reduced by reducing the types of components within the SIP. This leads to reduced development efforts and engineering costs. Further still, the PIP may be a predeveloped module, further reducing complexity and improving quality. Further, by providing a dedicated power supply in package (PIP), system costs of mainboards and the SIP are reduced in that the PIP is only provided when it is needed, compared to legacy arrangements where the typical mainboard would always include power rails, even if they are not required.

The PCB or PIP 200b may further include a plurality of power rails, each of the plurality of power rails coupled to a pad and coupled to the power circuit. In an embodiment, the PIP 200b may include anywhere between (and including) ten power rails and a 5000 power rails. In a preferred embodiment, the PIP 200b may include more than 30 power rails. In a further preferred embodiment, the PIP 200b may include 300 power rails. Advantageously, the PIP directly powers the SIP and the SIP does not have to be powered by the mainboard. Therefore, the mainboard does not require any dedicated layers to provide power to the SIP. Accordingly, the thickness (and thus the footprint) of the mainboard is reduced, thus providing improved packaging in computing systems.

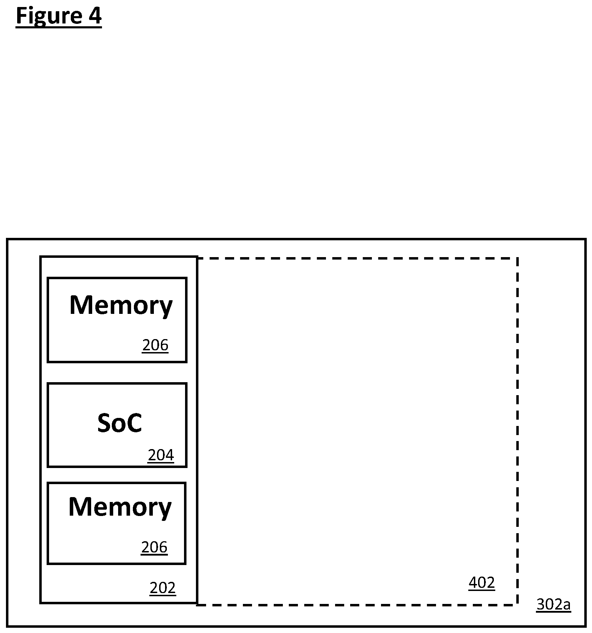

Figure 3 illustrates a side view of a system 300 and figure 4 illustrates a top-down view of the system 300 depicted in Figure 3. The system 300 includes a mainboard 302, wherein the mainboard 302 is a printed circuit board (PCB). The mainboard includes a first surface 302a on a top side of the mainboard 302 and a second surface 302b on a bottom side of the mainboard 302, wherein the top side is opposite to the bottom side. The system 300 includes a first substrate 202 (for example, the SIP 200a as described above) disposed on the first surface 302a of the mainboard 302. The first substrate 202 includes a first surface 202a on a top side of the first substrate 202 and a second surface 202b on a bottom side of the first substrate 202, wherein the top side is opposite to the bottom side. The system 300 includes a second substrate 208 (for example, the PIP 200b as described above) disposed on the second surface 302b of the mainboard 302. The second substrate 208 includes a first surface 208a on a top side of the second substrate 208 and a second surface 208b on a bottom side of the second substrate 208, wherein the top side 208a is opposite to the bottom side 208b. The mainboard 302 includes one or more through-silicon vias (TSVs) 304 between the first surface of the mainboard and the second surface of the mainboard, the one or more TSV electrically coupling the first substrate 202 to the second substrate 208.

Advantageously, a system with one or more SIPs is provided with improved packaging. By separating the power circuit to a separate power in package (PIP) on a PCB, both the upper and the lower sides of the mainboard can be used for packaging purposes. Valuable real estate on the (relative) upper side of the mainboard was previously reserved for the entire legacy SIP which included power circuits and power supplies in the SIP. With the present arrangement, the SIP takes up less space on the (relative) upper side of the mainboard which provides more space for more SIPs and/or more powerful SIPs (i.e. SIPs with increased memory and/or more complex SOC). Therefore, more complex and/or more powerful systems can be provided in a similar sized or indeed smaller package than in legacy systems.

In an embodiment, the first substrate 202 is a system in package (SIP). The SIP includes an integrated circuit (for example, integrated circuit or SOC 204 as described above) disposed on the first surface 202a of the first substrate 202 and memory (for example, memory 206) disposed on the first surface 202a of the first substrate 202, the memory 206 coupled to the integrated circuit 204. The SIP includes one or more pads 308 on the second surface 202b of the first substrate, each of the one or more pads 308 electrically coupled to the integrated circuit 204, wherein the one or more pads 308 are each electrically coupled to one or more of the through-silicon via (TSV) 304 of the mainboard 302, the one or more TSVs 304 coupled to a power circuit of the second substrate.

In an embodiment, the first substrate 202 may be one or more of a field-programmable gate array (FPGA), a compute process unit (CPU), a graphics process unit (GPU), or one or more ethernet switches. Advantageously, direct power can be provided to a plurality of different types of chips, arrays, and devices coupled to or disposed on a mainboard without the mainboard requiring power routing layers. Thus, the overall package size can be reduced. The first substrate 202 may include one or more pads 308 on the second surface 202b of the first substrate, each of the one or more pads 308 electrically coupled to the FPGA, the CPU, the GPU, the one or more ethernet switches, or any combination thereof. The one or more pads 308 are each electrically coupled to one or more of the through-silicon via (TSV) 304 of the mainboard 302, the one or more TSVs 304 coupled to a power circuit of the second substrate 208 (i.e. to a PIP as described herein).

In an embodiment, the second substrate 208 is a printed circuit board (PCB) or a PIP as described above. The PCB or PIP includes one or more power circuits (for example, power circuits 210 as described above) disposed on the second surface 208b of the second substrate 208. The PCB or PIP 208 includes one or more pads 306 on the first surface 208a of the substrate 208, each of the one or more pads 306 electrically coupled to the power circuit(s) 210, wherein the one or more pads 306 are each electrically coupled to the one or more through-silicon via (TSV) 304 of the mainboard, the one or more TSVs coupled to an integrated circuit 204 (and/or a memory 206) of the first substrate 202.

Advantageously, each SIP is provided with a dedicated PIP and each PIP has a dependency to a SIP. By providing a one to one mapping and mirroring of PIP to SIP (and SIP to PIP), systems can be increased in height (previously not utilised in similar systems) and minimised in length and width, thus increasing the density of the packaging and making packaging more versatile for multiple different types of applications.

In an embodiment, each of the pads 308 of the first substrate 202 are positioned directly above each of the pads 304 of the second substrate 208. Advantageously, each SIP is provided with a dedicated PIP with the shortest distance possible between the SIP and the dedicated PIP. Thus, direct power can be provided easily with the least amount of loss due to distance travelled by current.

In an embodiment, the first substrate 202 does not include a power circuit.

In an embodiment, each of the one or more power circuits 210 of the second substrate 208 provide power only to the first substrate 202. Advantageously, a dedicated and separate power supply (power in package, PIP) is provided for a SIP. SIPs with a dedicated and separate power supply can be designed to be a much smaller package due to the placement of a separate power circuit (or power supply) that is not part of the SIP. Such a SIP has all of the advantages of a legacy SIP with the added advantage of a reduced footprint, providing more space for system on a chip (SoC) and memory components. Further, by providing a dedicated power supply in package (PIP), system costs of mainboards and the SIP are reduced in that the PIP is only provided when it is needed, compared to legacy arrangements where the typical mainboard would always include power rails, even if they are not required.

In an embodiment, the mainboard 302 includes a plurality of signal routing layers. The mainboard may include 6, 7, or 8 signal routing layers. The signal routing layers may be operable to send and receive data to the SIP and to any other components coupled to the mainboard 302.

In an embodiment, the mainboard 302 does not include one or more power routing layers. Advantageously, the thickness (and thus the footprint) of the mainboard is reduced, thus providing improved packaging in computing systems. Typical mainboards may include a minimum of four and sometimes up to six or more power routing layers which increase the thickness of the mainboard and also decrease the efficiency of providing power from a single power source to any number of SIPs. A thinner mainboard (i.e. one with only 6 to 8 signal layers compared to a total of 12 to 14 layers including the signal layers and power layers) takes up less space and providing direct power (for example, by means of a dedicated PIP per SIP as described herein) ensures that power is efficiently delivered to each SIP (and/or each other powered component on the motherboard) with reduced voltage drop (and thus, increased efficiency). Moreover, power is typically only required at the mainboard where a SIP or other component is placed which, as shown in Figure 4, is typically in an area of 25% to 50% of the area of the mainboard 302. Therefore, in typical SIP and mainboard arrangements, 50% to 75% of the area is not used. With typical mainboard arrangements, the entire 100% of the mainboard is powered with the use of power routing layers, which leads to a large inefficiency. This inefficiency is addressed by removing the power layers from the mainboard (reducing the cost of manufacture) and by providing external PIPs where they are required, as described herein. Each PIP thus has the target of reducing voltage drop.

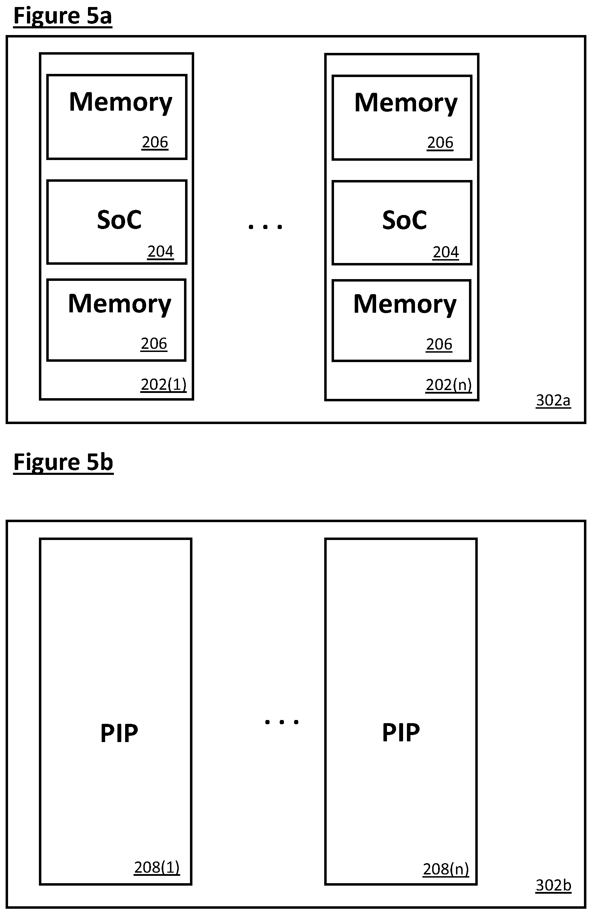

Figures 3 and 4 describe a system including one SIP (or one FPGA, CPU, GPU, one or more ethernet switches, or a combination thereof) 202 and one PIP 208 each disposed or mounted on a mainboard 302. However, the present invention is not limited to a system with only one SIP (or one FPGA, CPU, GPU, one or more ethernet switches, or a combination thereof) 202 and one PIP 208 pair. By providing a SIP (or one FPGA, CPU, GPU, one or more ethernet switches, or a combination thereof) as described herein without a power circuit, the SIP (or one FPGA, CPU, GPU, one or more ethernet switches, or a combination thereof) can be reduced in size drastically which leaves a larger void (as shown in 402 of figure 4) on the first surface 302(a) of the mainboard 302. This void 402 can used to add further SIPs (or further FPGA, CPU, GPU, ethernet switches, or a combination thereof) each with a corresponding PIP on the second surface 302(b) of the mainboard. Accordingly, the processing capability of the system 300 can be increased without drastically increasing the size of the mainboard 302 or the system 300. As shown in figures 5a and 5b, the system 300 may include two or any number of SIP/PIP pairs (or PIP paired with a FPGA, CPU, GPU, one or more ethernet switches, or a combination thereof). Figure 5a illustrates a top-down view of the system 300 including a first SIP (or further FPGA, CPU, GPU, ethernet switches, or a combination thereof) 202(1) and an n'th SIP (or further FPGA, CPU, GPU, ethernet switches, or a combination thereof)202(n) each disposed on the first surface 302(a) of the mainboard. Figure 5b illustrates a bottom-up view of the system 300 with a corresponding first PIP 208(1) and an n'th PIP 208(n) each disposed on the second surface 302(b) of the mainboard. Each PIP is mapped in a one-to-one arrangement to a SIP (or further FPGA, CPU, GPU, ethernet switches, or a combination thereof). In other words, each PIP is placed exactly below the SIP (or further FPGA, CPU, GPU, ethernet switches, or a combination thereof), as also indicated in figure 3.

In an embodiment, an electronic device is provided, the electronic device including the system 300 as described in figures 3, 4, 5a and 5b. The electronic device may be at least one of an automotive computer unit, an advanced driver-assistance system (ADAS) unit, a network ethernet router, a server, a user equipment device, or a personal computer.

## Claims

1. A system in package comprising:
a substrate, the substrate comprising a first surface on a top side of the substrate and a second surface on a bottom side of the substrate, wherein the top side is opposite to the bottom side;
an integrated circuit disposed on the first surface of the substrate;
memory disposed on the first surface of the substrate, the memory coupled to the integrated circuit;
one or more pads on the second surface of the substrate, each of the one or more pads electrically coupled to the integrated circuit;
wherein the one or more pads are each electrically coupled to a through-silicon via (TSV) of a mainboard, the one or more TSVs coupled to a power circuit of a second substrate, wherein the mainboard is a printed circuit board (PCB).

2. The system in package of claim 1, further comprising a plurality of power rails, each of the plurality of power rails coupled to a pad and coupled to the integrated circuit.

3. A printed circuit board comprising:
a substrate, the substrate comprising a first surface on a top side of the substrate and a second surface on a bottom side of the substrate, wherein the top side is opposite to the bottom side;
a power circuit disposed on the second surface of the substrate;
one or more pads on the first surface of the substrate, each of the one or more pads electrically coupled to the power circuit;
wherein the one or more pads are each electrically coupled to a through-silicon via (TSV) of a mainboard, the one or more TSVs coupled to an integrated circuit of a first substrate, wherein the mainboard is a printed circuit board (PCB).

4. The printed circuit board of claim 3, further comprising a plurality of power rails, each of the plurality of power rails coupled to a pad and coupled to the power circuit.

5. A system comprising:
a mainboard, wherein the mainboard is a printed circuit board (PCB), the mainboard comprising a first surface on a top side of the mainboard and a second surface on a bottom side of the mainboard, wherein the top side is opposite to the bottom side;
a first substrate disposed on the first surface of the mainboard, the first substrate comprising a first surface on a top side of the first substrate and a second surface on a bottom side of the first substrate, wherein the top side is opposite to the bottom side;
a second substrate disposed on the second surface of the mainboard, the second substrate comprising a first surface on a top side of the second substrate and a second surface on a bottom side of the second substrate, wherein the top side is opposite to the bottom side;
wherein the mainboard comprises one or more through-silicon vias (TSVs) between the first surface of the mainboard and the second surface of the mainboard, the one or more TSV electrically coupling the first substrate to the second substrate.

6. The system of claim 5, wherein the first substrate is a system in package comprising:
an integrated circuit disposed on the first surface of the first substrate;
memory disposed on the first surface of the first substrate, the memory coupled to the integrated circuit;
one or more pads on the second surface of the first substrate, each of the one or more pads electrically coupled to the integrated circuit;
wherein the one or more pads are each electrically coupled to the through-silicon via (TSV) of the mainboard, the one or more TSVs coupled to a power circuit of the second substrate.

7. The system of claim 5, wherein the first substrate is one or more of:
a field-programmable gate array (FPGA);
a compute process unit (CPU);
a graphics process unit (GPU); or
one or more ethernet switches.

8. The system of any one of claims 5 to 7, wherein the second substrate is a printed circuit board comprising:
a power circuit disposed on the second surface of the second substrate;
one or more pads on the first surface of the substrate, each of the one or more pads electrically coupled to the power circuit;
wherein the one or more pads are each electrically coupled to the through-silicon via (TSV) of the mainboard, the one or more TSVs coupled to an integrated circuit of the first substrate.

9. The system of claim 8, wherein each of the pads of the first substrate are positioned directly above each of the pads of the second substrate .

10. The system of any one of claims 5 to 9, wherein the first substrate does not comprise a power circuit.

11. The system of any one of claims 7 to 10, wherein the power circuit of the second substrate provides power only to the first substrate.

12. The system of any one of claims 5 to 11, wherein the mainboard comprises a plurality of signal routing layers.

13. The system of any one of claims 5 to 12, wherein the mainboard does not comprise a power routing layer.

14. An electronic device comprising the system of any one of claims 5 to 13.

15. The electronic device of claim 14, wherein the electronic device is at least one of:
An automotive computer unit;
An advanced driver-assistance system (ADAS) unit;
A network ethernet router;
A server;
A user equipment device; or
A personal computer.
